Europäisches Patentamt

(19) European Patent Office

Office européen des brevets

(11) Publication number: **0 355 935 B1**

(12) **EUROPEAN PATENT SPECIFICATION**

(45) Date of publication of patent specification :
**12.06.91 Bulletin 91/24**

(51) Int. Cl.[5]: **C08F 2/42**, C08F 6/02,
C08F 10/02

(21) Application number : **89202648.5**

(22) Date of filing : **30.09.85**

(54) Method of deactivating ethylene polymerization catalysts.

(30) Priority : **09.01.85 US 689953**

(43) Date of publication of application :
**28.02.90 Bulletin 90/09**

(61) Publication number of the earlier application in
accordance with Art. 76 EPC : **0191220**

(45) Publication of the grant of the patent :
**12.06.91 Bulletin 91/24**

(84) Designated Contracting States :
**BE DE FR GB IT NL**

(56) References cited :
**EP-A- 0 067 645**
**FR-A- 1 274 455**

(73) Proprietor : **QUANTUM CHEMICAL**
**CORPORATION**
**11500 Northlake Drive**
**Cincinnati, OH 45249 (US)**

(72) Inventor : **Hwang, Yu-Tang**
**1109 Moorland Avenue**
**Shorewood, IL 60435 (US)**
Inventor : **Pebsworth, Lloyd W.**
**304 Briar Lane**
**Morris, IL 60450 (US)**
Inventor : **Dombro, Robert A.**
**3013 Winterwood Drive**
**Springfield, IL 62704 (US)**
Inventor : **Hoff, Raymond E.**
**244 South Oak**
**Palatine, IL 60067 (US)**

(74) Representative : **Spencer, Graham Easdale et**
**al**
**A.A. Thornton & CO Northumberland House**
**303-306, High Holborn**
**London WC1V 7LE (GB)**

## Description

This invention is concerned generally with a method of terminating ethylene polymerization and copolymerization processes and, more specifically, with the deactivation of Ziegler catalysts used in such polymerization processes.

In polyethylene production generally, and particularly in the production of high density polyethylene (HDPE) or linear low density polyethylene copolymers (LLDPE) in high pressure reactors, it is necessary to terminate the polymerization reaction at a particular point in order to prevent the production of undesirable products, such as waxes, and low molecular weight materials, such as oligomers.

Typically in such processes, a catalyst comprising a transition metal compound, conventionally referred to as a "Ziegler catalyst", in association with an organometallic cocatalyst, is contacted with ethylene or ethylene and one or more 1-olefin or diolefin comonomers having at least three carbon atoms, under conditions of moderate to high pressure and high temperature. Under such conditions, ethylene is a liquid and acts as a solvent for the product polymer.

Typically, the product is discharged from the reactor in the form of a stream of polymer solution into one or more relatively low pressure separators where unpolymerized monomer and comonomer are removed from the polymer solution by evaporation.

The stream of polymer solution is actively polymerizing as it leaves the reactor since catalyst components are still present in the stream. It is therefore necessary to terminate the polymerization reaction by deactivating the catalyst components in order to avoid the production of undesirable by-products.

A known means of terminating ethylene polymerization reactions is described in U.S. Patent 4105609. This patent describes the use of an alkali metal salt or alkaline earth metal salt of a carboxylic acid, such as calcium stearate, as a deactivating agent for a Ziegler catalyst.

Other prior art deactivation methods use such deactivating agents as humidified calcium stearate, salts of alkali metals, inorganic polybasic acids and water, or water combined with an alkaline earth metal or zinc salt of an aliphatic monocarboxylic acid containing from 6 to 22 carbon atoms. Still other known deactivating agents include aqueous non-ionic surfactants and flux-calcined diatomite.

However, none of these prior art methods of catalyst deactivation have been completely satisfactory in terminating ethylene polymerization and copolymerization processes.

We have now found that Group IIIA metal salts of monocarboxylic acids are effective deactivators for such ethylene polymerization catalysts.

According to the present invention there is provided a method of homopolymerizing ethylene or interpolymerizing ethylene with one or more 1-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is a Group IIIA metal salt of a monocarboxylic acid.

The deactivating agent and the products of reaction between the agent and the components of the catalyst remain in the polymer solution and act as halogen scavengers, thereby providing a corrosion inhibiting effect in the process equipment.

The catalyst is quickly and effectively deactivated by the method of the invention, thereby preventing complications such as the formation of waxes and oligomers.

The method of the invention is suitable for polymerizing or copolymerizing, in batch or continuous processes, ethylene or ethylene and one or more 1-olefins or diolefins having at least three carbon atoms, under various conditions of pressure and temperature. The method of the invention is particularly suitable for polymerization processes using medium to high pressures and high temperatures. The preferred temperature range is from 130°C to 300°C with pressures preferably in the range of from 68.95-172.38 MPa (10,000 to 25,000 psig). Polymerization processes of this type are described in U.S. Patent 4105609.

The polymerization reaction may be carried out in a reactor of any convenient type, including, for example, stirred autoclave reactors and tubular reactors, or in a series of reactors of either the autoclave or tubular type. The polymerization conditions are preferably selected such that the reaction mixture of monomer, comonomer (if present), and polymer is homogeneous, i.e. the polymer is soluble in the reaction mixture.

If desired, chain transfer agents, such as hydrogen, or liquid diluents, such as liquid alkanes, can be present in the reaction mixture.

As is well known in the art, when polymerization is effected to form a solution of the product polymer in liquefied monomer(s), the polymer solution can be discharged as a stream from the reactor into a separator or series of separators which operate at low pressures relative to that of the reactor, in which the polymer is obtained from the polymer solution by degassing, that is vaporisation of the unreacted monomer and comonomer, which are then recycled to the reactor.

The stream of polymer solution which is discharged from the reactor still contains catalyst components. The present invention broadly contemplates the use of catalysts comprising a transition metal compound, conventionally referred to as "Ziegler catalysts", in association with an organometallic cocatalyst, such as an alkyl aluminium compound.

Such two component catalysts are well known in the art and the use of such catalysts is not critical to the practice of the invention. In general, such catalysts contain a transition metal, preferably titanium and/or vanadium, together with a Group IIA metal compound, such as an organomagnesium compound, or an organoaluminium compound.

In a preferred embodiment of the invention, the deactivator is added directly to the actively polymerizing stream of polymer solution, for example by injection, prior to degassing of the polymer solution. The deactivator may be introduced into the polymer stream in dry form, in admixture with water, or as a solution or suspension in an inert liquid diluent, such as mineral spirits. Preferably, the deactivator is added in a slurry form in an inert liquid diluent.

The amount of deactivator added to the polymerization mixture must, of course, be sufficient to ensure deactivation of the catalyst and termination of polymerization. Deactivation is effected by the destruction of at least one of the constituents of the catalyst, that is the transition metal derivative and/or the organometallic cocatalyst. It is preferred to use sufficient deactivator to react with all of the metallic components of the catalyst. Preferably from 0.1 to 10 moles of deactivator are used for each mole of metal in the catalyst.

Deactivation of a Ziegler catalyst in an actively polymerizing mixture by the method of the invention results in rapid, effective deactivation of the polymerization reaction, thereby preventing the formation of undesirable by-products, such as waxes, and low molecular weight products, such as oligomers. The deactivating agent reacts with the metallic components of the Ziegler catalyst system and the reaction products and any unreacted deactivating agent remain in the polymer after monomer removal.

An important benefit of the invention is the halogen scavenging ability of the deactivators, which significantly inhibits corrosion of process equipment when the deactivator and its reaction products with the components of the catalyst system remain in the polymer. For example, chloride in the catalyst is effectively neutralised by the method according to the invention. The invention also provides ready control of the composition of the gases recycled to the reactor from the low pressure separators, thereby allowing ready control of the relative amounts of the constitutents in the reactor.

The Group IIIA metal salts of monocarboxylic acids which are used as the deactivator in accordance with the invention, may be used in combination with some of the corresponding free monocarboxylic acid, if desired. A preferred Group IIIA metal salt suitable for use in the method of the invention is aluminium stearate.

In order that the invention may be more fully understood, the following examples are given by way of illustration.

## Examples

A series of ethylene/1-butene copolymerization reactions were carried out in a one-litre autoclave reactor equipped with a catalyst injector and a separate deactivator injector. Isopar H (supplied by Exxon) was used as a diluent. An alkyl aluminium cocatalyst, liquid ethylene at 3.44 MPa (500 psig), and 15% by weight of 1-butene were placed in the reactor at 220°C and a titanium/magnesium catalyst was injected under nitrogen pressure. The rate of reaction was monitored and when maximum reactivity was achieved, the deactivator compound was injected under nitrogen pressure. The effectiveness of each deactivator was measured in terms of the number of seconds required after the deactivator had been injected into the active polymerization zone for the ethylene flow to fall to less than 5% compared with a blank test in which no deactivator was injected. The compound injected was considered to be an effective deactivator if it reduced the ethylene flow to less than 5% within 30 seconds of its injection into the polymerization mixture.

The following Table shows the results obtained :

TABLE

| Example | Deactivator | Mole Ratio Deactivator to Catalyst[b] | Ethylene Flow at Time of Deactivator Injection, % | Maximum Ethylene Flow Reached, % | Time to Deactivate Seconds[c] |
|---|---|---|---|---|---|
| 1 | None[a] | – | – | 55 | 120 |
| 2 | Aluminium Stearate[d] | 0.125 | 35 | 45 | 31 |
| 3 | " | 0.25 | 64 | 64 | 27 |
| 4 | " | 0.5 | 25 | 29 | 23 |
| 5 | " | 1.0 | 17 | 24 | 23 |

Footnotes to Table

a) Blank test.
b) The catalyst contains compounds of titanium, magnesium and aluminium.
c) Time required to fall to 5% ethylene flow following injection of deactivator compound.
d) Grade V from Diamond Shamrock ; 14 wt.% in Isopar H.

## Claims

1. A method of homopolymerizing ethylene or interpolymerizing ethylene with one or more 1-olefins or diolefins having at least three carbon atoms by subjecting the monomer(s) to polymerizing conditions in a reactor in the presence of a catalyst which comprises a transition metal derivative, and terminating the polymerization by adding a catalyst deactivator to the polymerization mixture or a part thereof, characterised in that the deactivator is a Group IIIA metal salt of a monocarboxylic acid.

2. A method according to claim 1, in which the polymerization mixture consists of a solution of the polymer obtained in liquefied, unpolymerized, monomer(s), a portion of the polymerization mixture is removed from the reactor, the deactivator is added thereto, and the unpolymerized monomer(s) is/are removed by evaporation.

3. A method according to claim 1 or 2, in which from 0.1 to 10 moles of the deactivator are added per mole of metal in the catalyst.

4. A method according to any of claims 1 to 3, in which the deactivator is a mixture of said metal salt and the corresponding free monocarboxylic acid.

5. A method according to any of claims 1 to 3, in which the deactivator is aluminium stearate.

## Ansprüche

1. Verfahren zur Homopolymerisation von Ethylen oder Interpolymerisation von Ethylen mit einem oder mehreren 1-Olefinen oder Diolefinen mit wenigstens 3 C-Atomen durch Unterwerfung des oder der Monomeren unter Polymerisationsbedingungen in einem Reaktor in Gegenwart eines Katalysators, der ein Übergangsmetallderivat enthält, und Beenden der Polymerisation durch Zugabe eines Katalysatordeaktivators zu der Polymerisationsmischung oder einem Teil davon, dadurch **gekennzeichnet**, daß der Deaktivator ein Salz einer Monocarbonsäure mit einem Metall der III A-Gruppe ist.

2. Verfahren gemäß Anspruch 1, dadurch **gekennzeichnet**, daß die Polymerisationsmischung aus der Lösung des in dem oder den verflüssigten unpolymerisierten Monomeren hergestellten Polymeren besteht, ein Teil der Polymerisationsmischung aus dem Reaktor entfernt wird, der Deaktivator dazu zugesetzt wird und die nicht polymerisierten Monomeren durch Verdampfen entfernt werden.

3. Verfahren gemäß Anspruch 1 oder 2, dadurch **gekennzeichnet**, daß 0,1 bis 10 Mol des Deaktivators je Mol des Metalls in dem Katalysator zugesetzt werden.

4. Verfahren gemäß einem jeden der Ansprüche 1 bis 3, dadurch **gekennzeichnet**, daß der Deaktivator eine Mischung aus dem Metallsalz und der korrespondierenden freien Monocarbonsäure ist.

5. Verfahren gemäß einem jeden der Ansprüche 1 bis 3, dadurch **gekennzeichnet**, daß der Deaktivator Aluminiumstearat ist.

## Revendications

1. Une méthode d'homopolymérisation de l'éthylène ou d'interpolymérisation de l'éthylène avec une ou plusieurs 1-oléfines ou dioléfines ayant au moins trois atomes de carbone consistant à soumettre le ou les monomères à des conditions de polymérisation dans un réacteur en présence d'un catalyseur qui comprend un dérivé de métal de transition, et à terminer la polymèrisation par addition d'un agent désactivant le catalyseur au mélange de polymérisation ou à une partie de ce dernier, caractérisée en ce que l'agent désactivant est un sel de métal du groupe IIIA d'un acide monocarboxylique.

2. Une méthode selon la revendication 1, selon laquelle le mélange de polymérisation consiste en une solution du polymère obtenu dans le ou les monomères liquéfiés, non polymérisés, une portion du mélange de polymérisation est séparée du réacteur, l'agent désactivant est ajouté à cette portion et le ou les monomères non polymérisés sont séparés par évaporation.

3. Une méthode selon la revendication 1 ou 2, selon laquelle de 0,1 à 10 moles de l'agent désactivant sont

EP 0 355 935 B1

ajoutées par mole de métal dans le catalyseur.

4. Une méthode selon l'une quelconque des revendications 1 à 3, selon laquelle l'agent désactivant est un mélange dudit sel métallique et de l'acide monocarboxylique libre correspondant.

5. Une méthode selon l'une quelconque des revendications 1 à 3, selon laquelle l'agent désactivant est le stéarate d'aluminium.

6